# EUROPEAN PATENT APPLICATION

(11) **EP 1 878 736 A1**
(43) Date of publication of application: **16.01.2008**
(21) Application number: 06715077.1
(22) Date of filing: 02.03.2006
(51) Int. Cl.: C07F 7/18

(54) **COATED HETEROAROMATIC RING COMPOUND**

(30) Priority: 09.03.2005 JP 2005065947
(71) Applicant: OSAKA UNIVERSITY, Suita-shi, Osaka 565-0871 (JP); Japan Science and Technology Agency, Kawaguchi-shi, Saitama 332-0012 (JP)
(72) Inventor: ASO, Yoshio, Osaka 565-0871 (JP); IE, Yutaka, Osaka 565-0871 (JP); HAN, Aihong, Shen Yang City Liao Ning Province 110021 (CN)
(74) Representative: Golding, Louise Ann
(86) International application number: PCT/JP2006/303968
(87) International publication number: WO 2006/095631

(57) **Abstract**

The present invention provide a covered heteroaromatic ring compound whose hetero ring effectively is covered and that is suitable for electronic materials and the like. For example, following Scheme 1 below, first, a thiophene monomer unit (1T) is synthesized, and then oligomers (2T) to (16T) are synthesized by repeating oxidative polymerization. The hetero ring is not limited to thiophene, and may be furan or pyrrole, for example. Also, substituents on silicon are not limited to those in Scheme 1, and any substituents may be used. The degree of polymerization and the synthesis method are not limited to those in Scheme 1. In the compound of the present invention, π electronic conjugation effectively is kept as shown in the ultraviolet and visible absorption spectrum in FIG. 1, for example. Accordingly, the compound is useful, for example, as a research tool for clarifying electrical properties according to the degree of polymerization of oligoheterocyclic compounds, and as molecular wires that are important in molecular electronics devices.

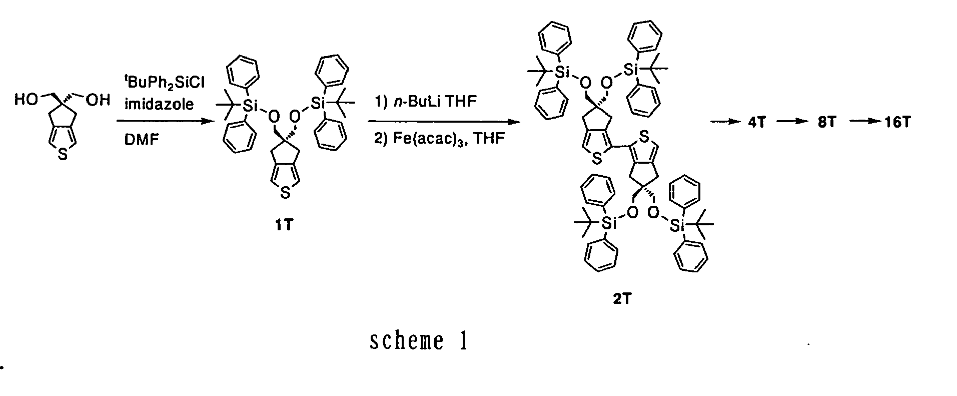

## Description

### Technical Field

The present invention relates to a covered heteroaromatic ring compound.

### Background Art

Heteroaromatic rings such as thiophene rings show characteristic properties according to the degree of polymerization when π electronic conjugation is expanded by polymerization. Thus, in particular, oligothiophene containing a thiophene ring polymerized structure, and its derivatives have been researched extensively in view of application to electronic materials, for example.

In research for applying oligothiophene and its derivatives to electronic materials, first, in order to clarify electrical properties according to the degree of polymerization of the oligothiophene structure, it is important to measure electrical properties such as the electrical conductivity of oligothiophene monomolecules. From this point of view, research has been conducted extensively for covering the oligothiophene structure with bulky substituents (Non-patent Documents 1 to 5, for example), because it seems that when the oligothiophene structure is covered in this manner, the planarity of the oligothiophene structure is kept, π-stacking interaction between molecules and the like is inhibited, and thus π electronic conjugation in the oligothiophene structure effectively is maintained. Furthermore, research also has been conducted for effectively keeping π electronic conjugation in the oligothiophene structure in this manner, thereby allowing the compound to be applied to so-called nano-level molecular wires of molecular electronics.

However, up to the present, it is difficult to produce oligothiophene and other oligoheterocyclic compounds in which conjugated chains effectively are covered without impairing the effective conjugation length.

[Non-patent Document 1] Aso, Y.; Otsubo, T. et al. J. Am. Chem. Soc. 2003, 125, 5286.
[Non-patent Document 2] Otsubo, T.; Ueno, S.; Takimiya, K.; and Aso, Y. Chemistry Letters 2004, 33(9), 1154.
[Non-patent Document 3] Tanaka, S. and Yamashita, Y. Synthetic Metals 1999, 101, 532.
[Non-patent Document 4] Tanaka, S. and Yamashita, Y. Synthetic Metals 2001, 119, 67.
[Non-patent Document 5] Wakamiya, A.; Yamazaki, D.; Nishinaga, T.; Kitagawa, T. and Komatsu, K. J. Org. Chem. 2003, 68, 8305.

### Disclosure of Invention

### Problem to be Solved by Invention

It is an object of the present invention to provide a covered heteroaromatic ring compound whose hetero ring effectively is covered and that is suitable for electronic materials and the like.

### Means for Solving Problem

In order to solve the above-described problem, a covered heteroaromatic ring compound of the present invention (hereinafter, also referred to simply as "compound of the present invention") is compound represented by Formula (I), a tautomer or a stereoisomer thereof, or a salt thereof.

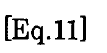

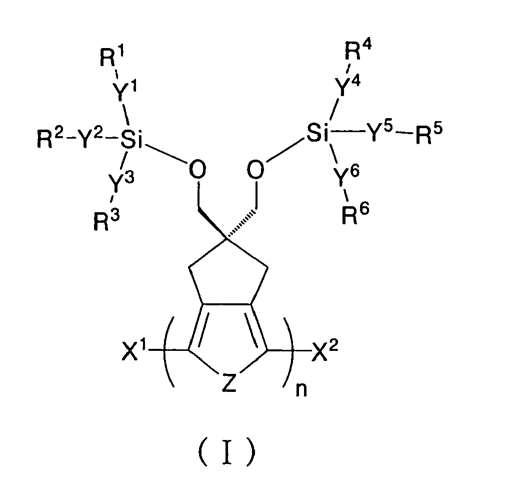

In Formula (I),
Y¹ to Y⁶ each independently are an oxygen atom or a bond,
R¹ to R⁶ each independently are a hydrogen atom, linear chain or branched chain (may or may not contain a hetero atom, may or may not contain an unsaturated bond, and may or may not contain a ring structure, in the main chain and side chain), or a carbocyclic ring or a hetero ring (may be a monocyclic ring or a fused ring, may be saturated or unsaturated, and may or may not have a substituent), or at least two of R¹ to R³ together may form a ring with a silicon atom bonded thereto, and at least two of R⁴ to R⁶ together may form a ring with a silicon atom bonded thereto,
Z is an atom or an atomic group represented by any one of Formulae (i) to (vii).

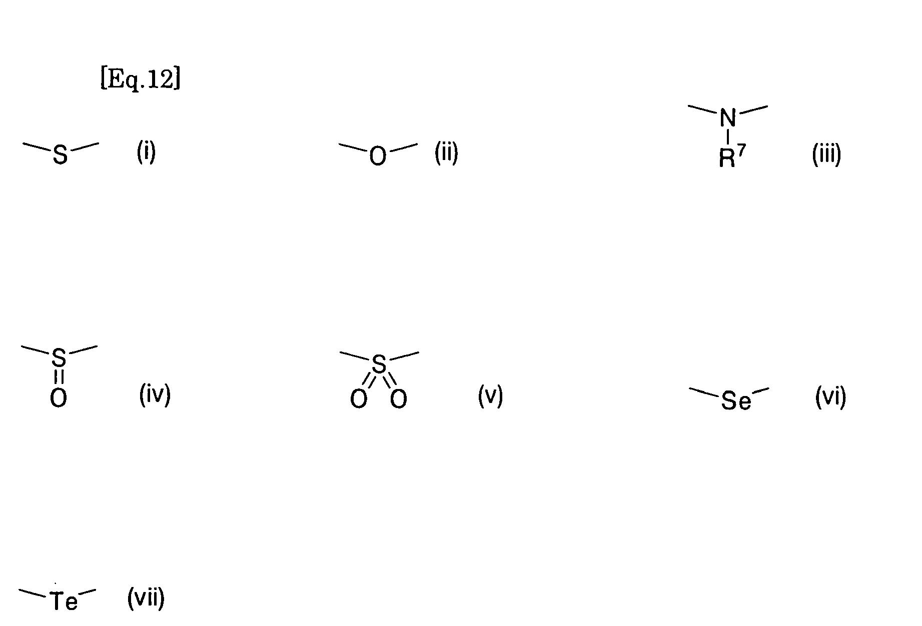

R⁷ is a hydrogen atom or a hydrocarbon group (may be saturated or unsaturated, and may be linear, branched, or cyclic), and further may be substituted with at least one substituent,
X¹ and X² each independently are a hydrogen atom or a polar group, and
n is a positive integer.

### Effect of Invention

The compound of the present invention has the structure represented by Formula (I) above, so that its hetero ring effectively is covered, and the compound is suitable for electronic materials and the like.

### Brief Description of Drawings

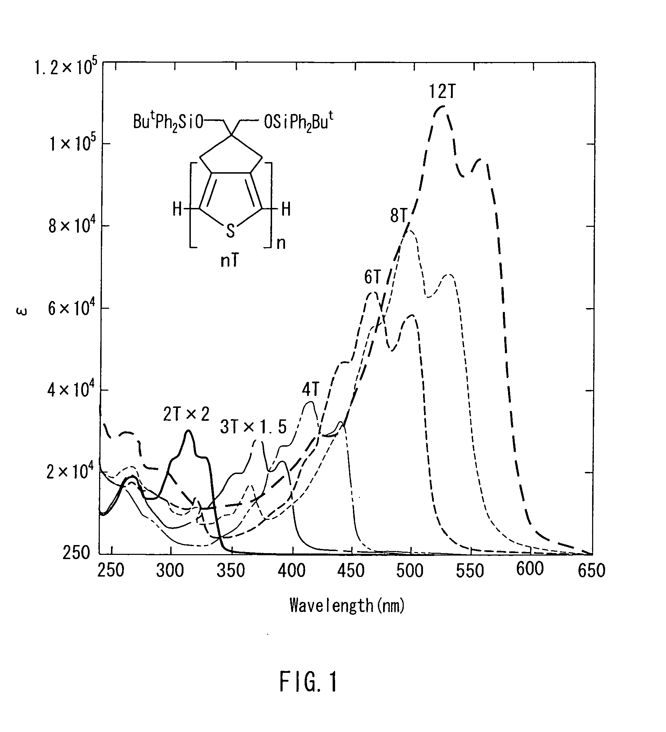

[FIG. 1] FIG. 1 shows an ultraviolet and visible absorption spectrum of the compound of an example.

### Best Mode for Carrying Out the Invention

Next, the present invention is described in more detail.

The compound of the present invention may be a polymeric compound as shown in Formula (I) above, or may be a monomer. It should be noted that polymeric compounds include "polymers" and "oligomers", which are not necessarily distinguished clearly from each other. However, in the present invention, molecules that can be isolated as molecular aggregates having a uniform degree of polymerization are referred to as "oligomers", and molecules that can not be isolated as molecular aggregates having a uniform degree of polymerization are referred to as "polymers". In a case where the compound of the present invention is a polymeric compound, the compound may be either an oligomer or a polymer, but an oligomer is preferable because the electrical properties and the like can be set freely according to the degree of polymerization, for example.

Furthermore, in a case where the compound represented by Formula (I) above has isomers such as tautomers, stereoisomers, or optical isomers, these isomers also are included in the compound of the present invention. Furthermore, in a case where the compound of Formula (I) above or isomers thereof may form salts, the salts also are included in the compound of the present invention. There is no particular limitation on the salts, and the salts may be acid addition salts, or may be base addition salts, for example. Moreover, acids forming the acid addition salts may be inorganic acids, or may be organic acids. Bases forming the base addition salts may be inorganic bases, or may be organic bases. There is no particular limitation on the inorganic acids, and examples thereof include sulfuric acid, phosphoric acid, hydrochloric acid, hydrobromic acid, and hydroiodic acid. Also, there is no particular limitation on the organic acids, and examples thereof include p-toluenesulfonic acid, methanesulfonic acid, oxalic acid, p-bromobenzenesulfonate, carbonic acid, succinic acid, citric acid, benzoic acid, and acetic acid. There is no particular limitation on the inorganic bases, and examples thereof include ammonium hydroxide, alkali metal hydroxide, alkaline earth metal hydroxide, carbonate, and hydrogen carbonate, and more specifically include sodium hydroxide, potassium hydroxide, potassium carbonate, sodium carbonate, sodium hydrogen carbonate, potassium hydrogen carbonate, calcium hydroxide, and calcium carbonate. Also, there is no particular limitation on the organic bases, and examples thereof include ethanolamine, triethylamine, and tris(hydroxymethyl)aminomethane. There is no particular limitation on methods for producing the salts of the compound of the present invention, and the salts can be produced by adding the above-described acids or bases to the compound of the present invention as appropriate by known methods, for example.

In Formula (I) above, it is preferable that R¹ to R⁶ each independently are a hydrogen atom, linear chain or branched chain having 1 to 18 carbon atoms (may or may not contain a hetero atom, may or may not contain an unsaturated bond, and may or may not contain a ring structure, in the main chain and side chain), or a cyclic substituent having a structure in which any one hydrogen has been removed from the compound represented by any one of Formulae (1) to (67) below (the cyclic substituent further may be substituted with one or a plurality of substituents, and the substituents each independently are halogen, a methyl group, a hydroxy group, a methoxy group, an oxo group, or an amino group).

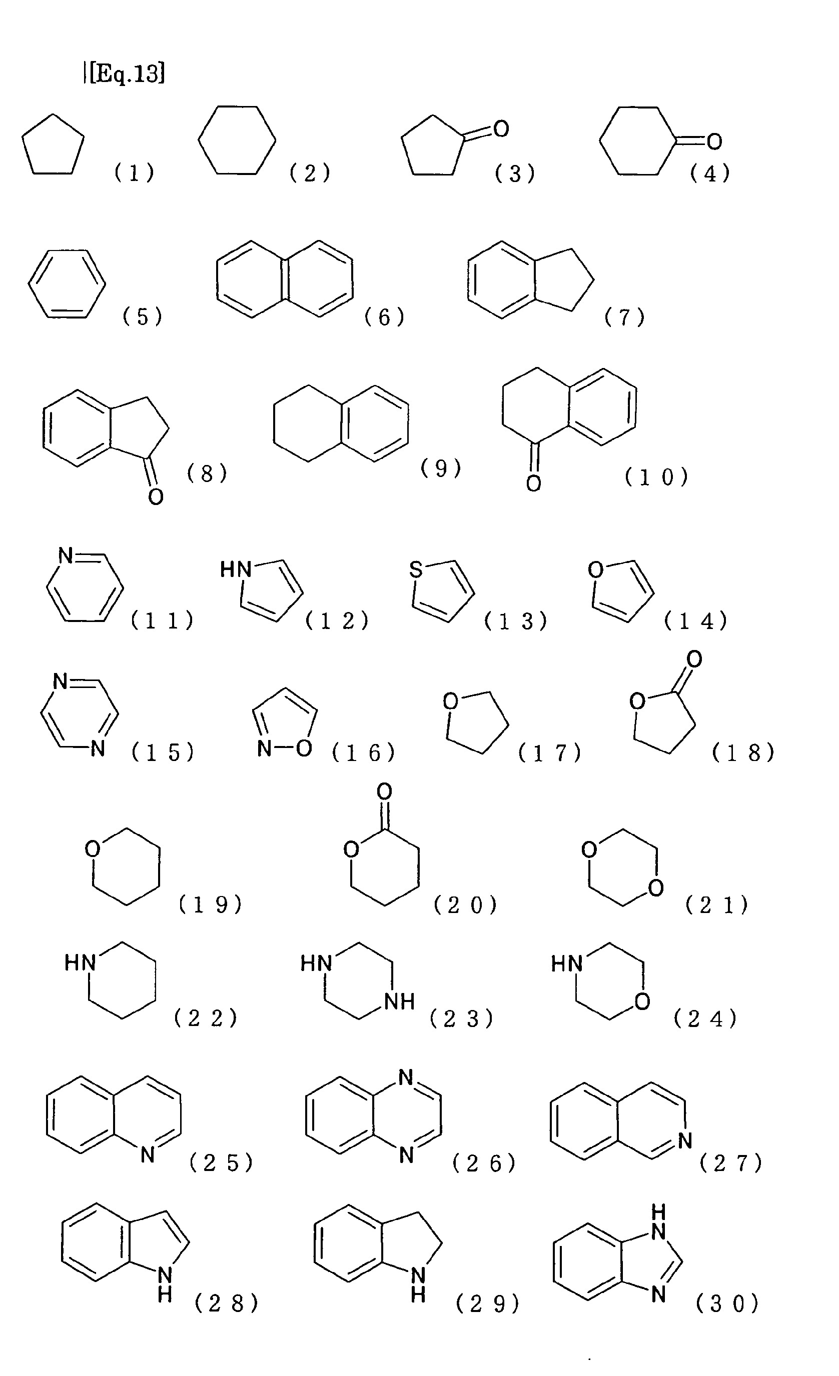

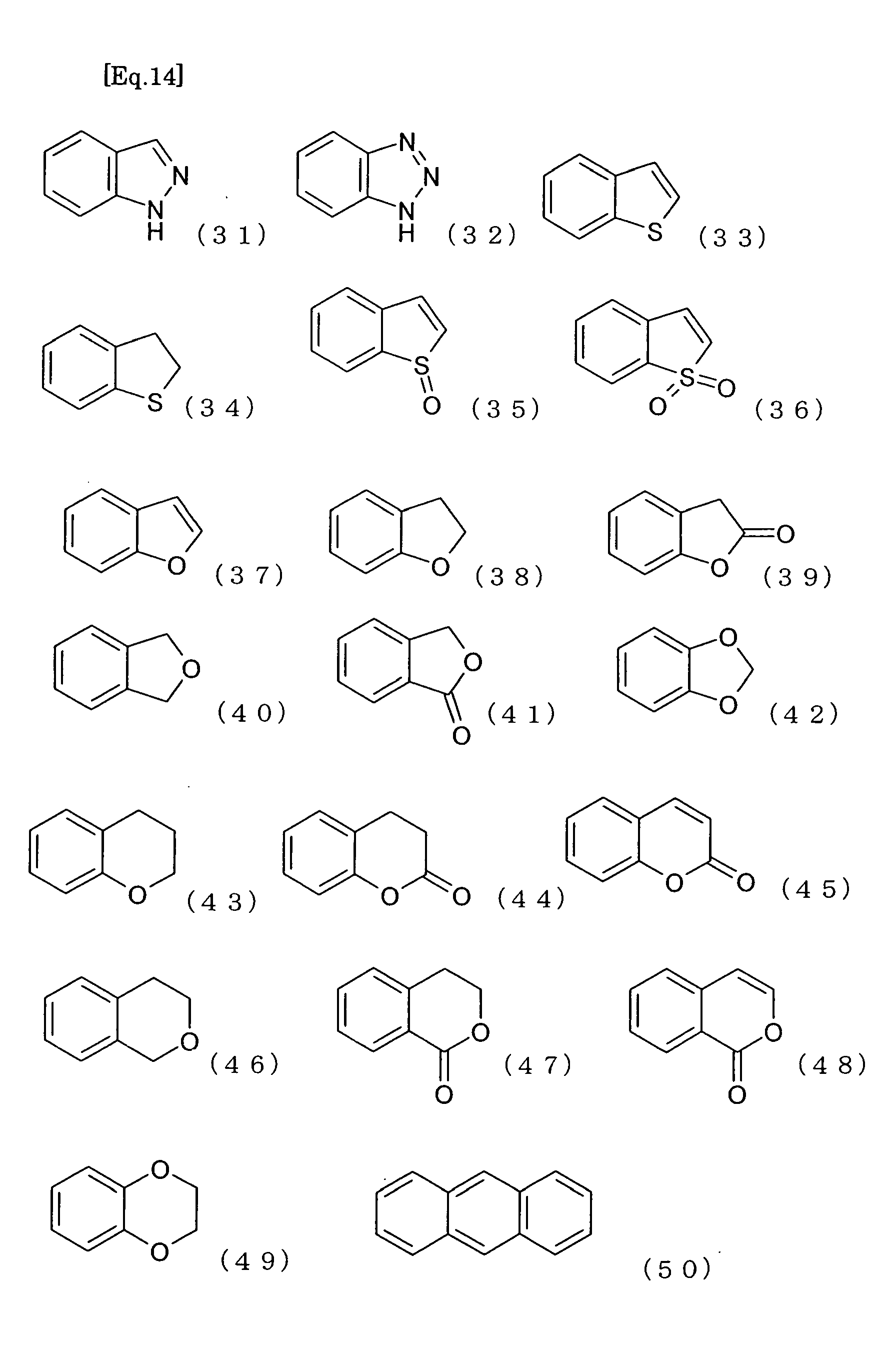

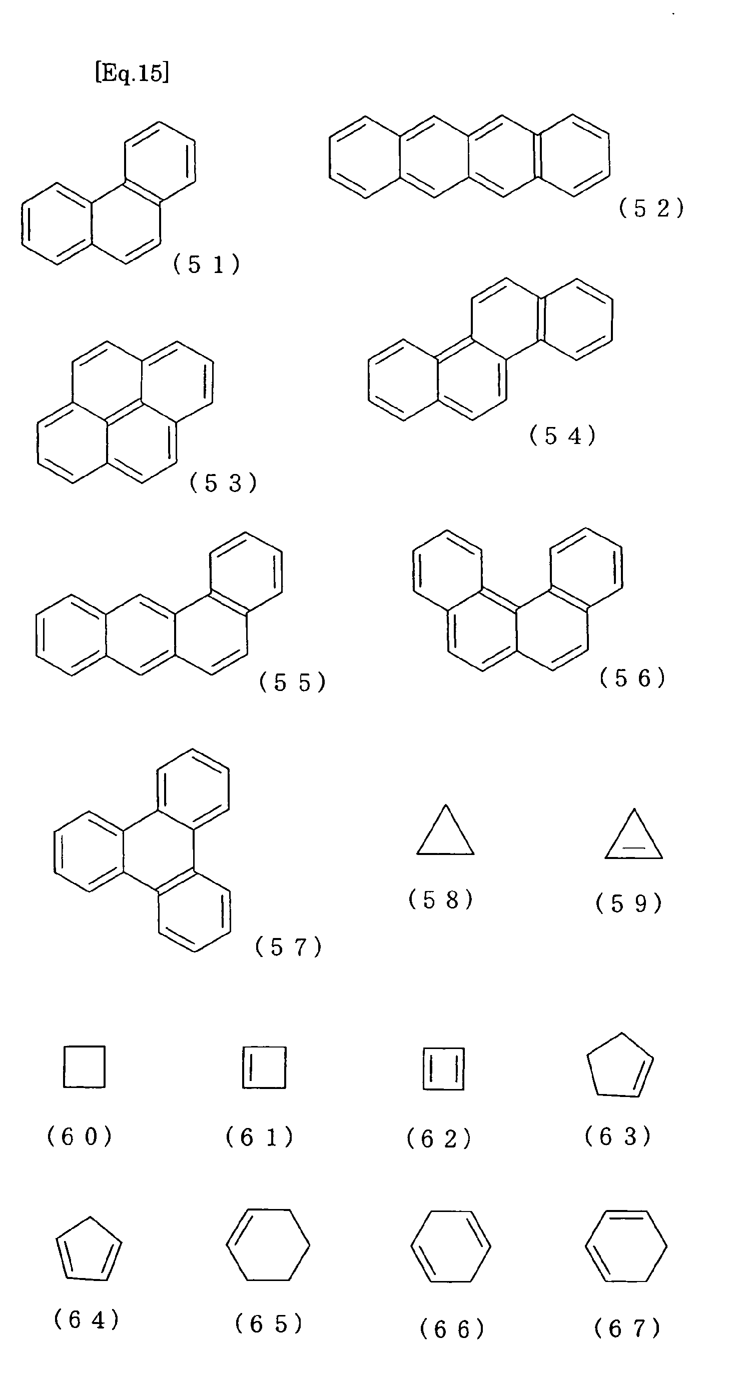

Furthermore, two or more of R¹ to R³ together may form a ring with a silicon atom bonded thereto. Two or more of R⁴ to R⁶ together may form a ring with a silicon atom bonded thereto.

Furthermore, in Formula (I) above, it is more preferable that R¹ to R⁶ each independently are a hydrogen atom, a linear or branched alkyl group having 1 to 18 carbon atoms, a linear or branched unsaturated hydrocarbon group having 2 to 18 carbon atoms, a phenyl group, a 1-naphthyl group, a 2-naphthyl group, a 1-anthryl group, a 2-anthryl group, or a 9-anthryl group. These groups further may be substituted with one or more substituents. Two or more of R¹ to R³ together may form a ring with a silicon atom bonded thereto. Two or more of R⁴ to R⁶ together may form a ring with a silicon atom bonded thereto. R⁷ is a hydrogen atom, a linear or branched alkyl group having 1 to 6 carbon atoms, or a linear or branched unsaturated hydrocarbon group having 2 to 6 carbon atoms, and further may be substituted with one or more substituents.

Furthermore, in Formula (I) above, it is even more preferable that R¹ to R⁶ each independently are a hydrogen atom, a linear or branched alkyl group having 1 to 6 carbon atoms, a linear or branched unsaturated hydrocarbon group having 2 to 6 carbon atoms, a phenyl group, a 1-naphthyl group, a 2-naphthyl group, a 1-anthryl group, a 2-anthryl group, or a 9-anthryl group, and that R⁷ is a hydrogen atom or a methyl group.

It should be noted that in the present invention, "halogen" refers to any halogen element, and examples thereof include fluorine, chlorine, bromine, and iodine. There is no particular limitation on the alkyl group, and examples thereof include a methyl group, an ethyl group, an n-propyl group, an isopropyl group, an n-butyl group, an isobutyl group, a sec-butyl group, and a tert-butyl group. There is no particular limitation on the unsaturated hydrocarbon group, and examples thereof include a vinyl group, a 1-propenyl group, an allyl group, a propargyl group, an isopropenyl group, a 1-butenyl group, and a 2-butenyl group.

Furthermore, in Formula (I) above, it is still more preferable that R¹ to R⁶ each independently are a hydrogen atom, a methyl group, an ethyl group, an n-propyl group, an isopropyl group, an n-butyl group, an isobutyl group, a sec-butyl group, a tert-butyl group, a phenyl group, a 1-naphthyl group, a 2-naphthyl group, a 1-anthryl group, a 2-anthryl group, or a 9-anthryl group, and that R⁷ is a hydrogen atom or a methyl group.

In Formula (I) above, for example, a compound represented by Formula (II) below, a tautomer or a stereoisomer thereof, or a salt thereof is particularly preferable.

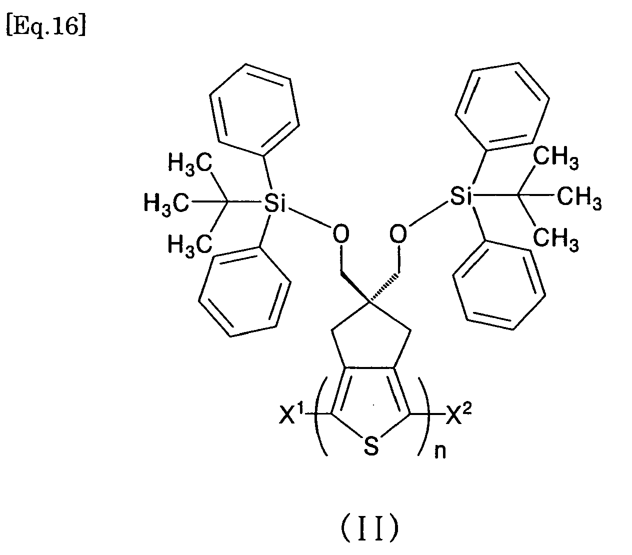

In Formula (II), X¹, X², and n respectively are the same as those in Formula (I) above. In the compound represented by Formula (II), the rigidity is kept by a tert-butyldiphenylsilyl group (TBDPS group) that is disposed perpendicular to a conjugated chain, and thus an effective conjugation length is not impaired. Furthermore, since the TBDPS group three-dimensionally is bulky, the conjugated chain effectively can be shielded from the outside.

It should be noted that X¹ and X² may be a hydrogen atom, but their being a polar group such as a mercapto group is effective at the time of attachment to an electrode, as a molecular wire, for example. It is preferable that X¹ and X² each independently are a hydrogen atom, a mercapto group (-SH), or a substituent represented by any one of Formulae (viii) to (xvi) below, for example.

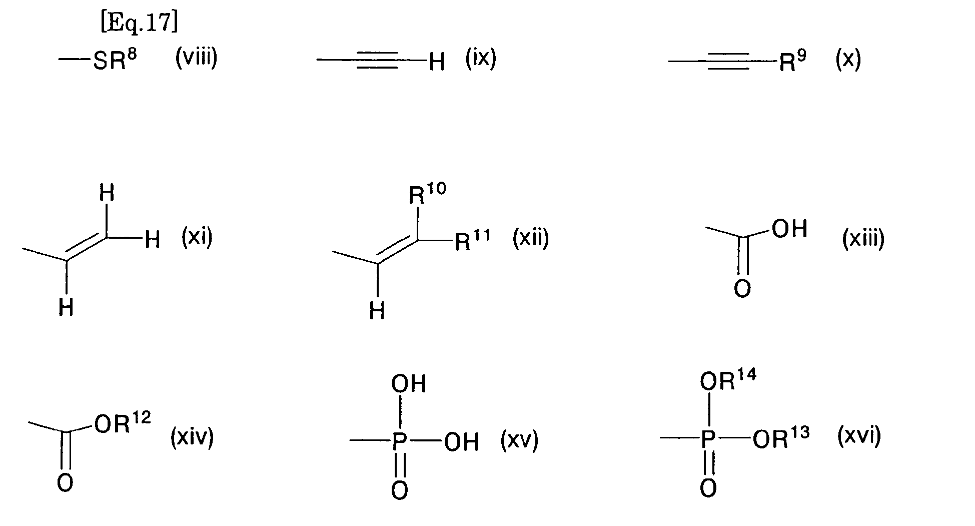

In Formulae (viii) to (xvi), R⁸ to R¹⁴ each independently may be a linear or branched alkyl group, a cycloalkyl group, or an aromatic ring, one of R¹⁰ and R¹¹ may be a hydrogen atom, and one of R¹³ and R¹⁴ may be a hydrogen atom. There is no particular limitation on the alkyl group, but, for example, a linear or branched alkyl group having 1 to 18 carbon atoms is preferable, and a linear or branched alkyl group having 1 to 6 carbon atoms is more preferable. There is no particular limitation on the cycloalkyl group, but, for example, a cyclopentyl group, a cyclohexyl group, or a cycloheptyl group is preferable. There is no particular limitation on the aromatic ring, but, for example, a phenyl group, a 1-naphthyl group, a 2-naphthyl group, a 1-anthryl group, a 2-anthryl group, or a 9-anthryl group is preferable.

Furthermore, in Formula (I) above, there is no particular limitation on a degree of polymerization n, but, for example, a multiple of 2 is preferable, and 1 to 96 are preferable, and 1, 2, 4, 6, 8, 12, or 16 particularly is preferable. As described above, the compound of the present invention may be either a monomer or a polymeric compound. In a case where this compound of the present invention is a polymeric compound, the compound may be either an oligomer or a polymer, but an oligomer is preferable. The definitions of "polymer" and "oligomer" are as described above.

Next, the molecular aggregate of the present invention is a molecular aggregate constituted by the compounds represented by Formula (I) above, tautomers or stereoisomers thereof, or salts thereof, and is a molecular aggregate having a uniform degree of polymerization n of the compound molecules in the molecular aggregate.

The molecular aggregate constituted by the compounds of the present invention preferably can be used for electronic materials and the like, even if the degree of polymerization of the compound molecules is not uniform. However, as described above, the molecular aggregate having a uniform degree of polymerization n shows characteristic properties according to the degree of polymerization, and thus such a molecular aggregate is preferable because the electrical properties and the like can be set freely according to the degree of polymerization.

Furthermore, the molecular aggregate of the present invention having a uniform degree of polymerization n of the compound molecules preferably can be used for measuring electrical properties such as electrical conductivity of the framework represented by Formula (VII) below, for example.

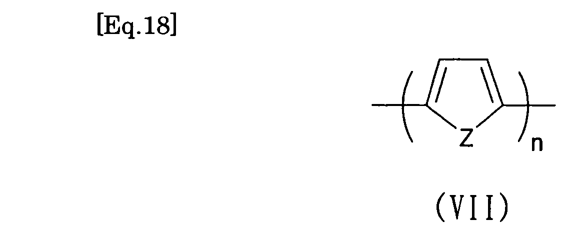

In Formula (VII), Z and n respectively are the same as those in Formula (I) above.

As described above, in research for applying oligothiophene and its derivatives to electronic materials, first, in order to clarify electrical properties according to the degree of polymerization of the oligothiophene structure, it is important to measure electrical properties such as the electrical conductivity of oligothiophene monomolecules. The same is applicable even when the thiophene is substituted with another heteroaromatic ring. From this point of view, the molecular aggregate of the present invention having a uniform degree of polymerization n is useful also as a research tool for clarifying electrical properties according to the degree of polymerization of oligoheterocyclic compounds.

Furthermore, electronic materials or semiconductors of the present invention exert excellent electrical properties when containing the compound represented by Formula (I) above, a tautomer or a stereoisomer thereof, or a salt thereof, or the molecular aggregate of the present invention. In particular, when the molecular aggregate of the present invention having a uniform degree of polymerization n is contained, the electrical properties can be set freely according to the degree of polymerization.

Next, a method for producing the compound of the present invention is described.

There is no particular limitation on the method for producing the compound of the present invention, and any methods may be applied, but a production method of the present invention described below is preferable. More specifically, first, the production method of the present invention is a method for producing the compound represented by Formula (I) above, a tautomer or a stereoisomer thereof, or a salt thereof, comprising a step of producing a compound represented by Formula (VI) below by a coupling reaction of compounds represented by Formulae (III) to (V) below.

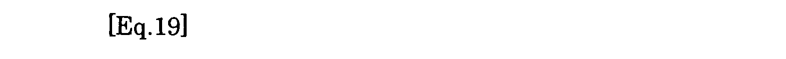

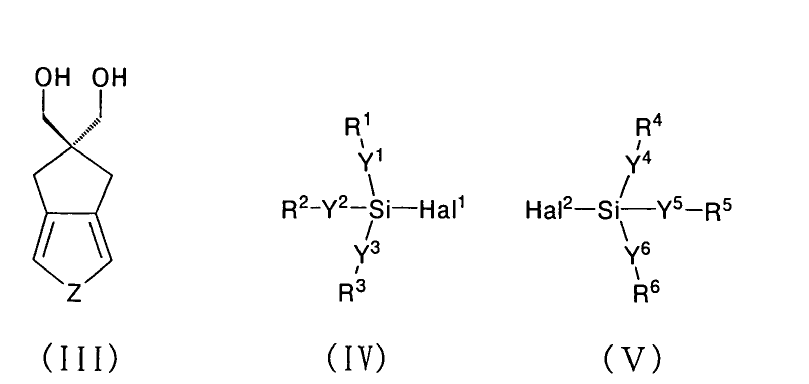

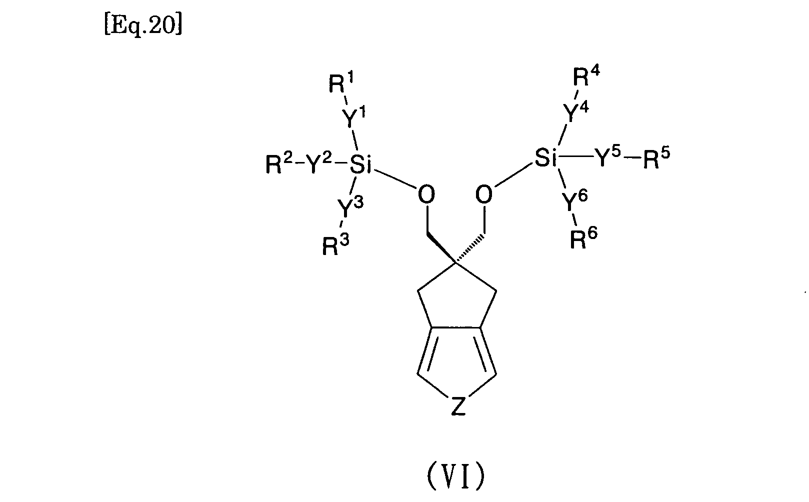

In Formulae (III) to (VI), Y¹ to Y⁶, R¹ to R⁶, and Z respectively are the same as those in Formula (I) above, and Hal¹ and Hal² each independently are chlorine, bromine, or iodine.

There is no particular limitation on the conditions of the coupling reaction, and the conditions may be selected as appropriate referring to known conditions of coupling reaction between alcohol and silyl halide, for example. For example, under conditions where a base such as imidazole coexists in an amide solvent such as dimethylformamide, dimethylacetamide or n-methylpyrrolidone (NMP) or an aprotic solvent, the compounds represented by Formulae (III) to (V) above may be subjected to a coupling reaction. Also, there is no particular limitation on reaction temperature, and the temperature may be selected as appropriate according to the type or the like of starting materials (the compounds represented by Formulae (III) to (V) above). Examples thereof include -20°C to 200°C, and preferably include 0°C to 100°C. Furthermore, solvents, reagents, and the like are not limited to those described above, and can be selected as appropriate.

Next, the production method of the present invention preferably further comprises a step of polymerizing the compound represented by Formula (VI) above, and more preferably comprises a step of further polymerizing a product obtained in the polymerization step. Using the polymerization step in this manner, the degree of polymerization freely can be controlled.

There is no particular limitation on the polymerization, and, for example, a reaction that is known as a polymerization reaction for hetero rings can be used as appropriate. Of these, for example, oxidative polymerization using an organic lithiation agent is preferable. There is no particular limitation on reaction conditions, reagents, and the like, and they can be selected as appropriate referring to conventionally known oxidative polymerization reaction, for example. There is no particular limitation on the organic lithiation agent, and examples thereof include n-butyllithium, sec-butyllithium, iso-butyllithium, tert-butyllithium, and phenyllithium. Furthermore, if necessary, solvents may be used. There is no particular limitation on the solvents, and examples thereof include ether such as diethyl ether, tetrahydrofuran (THF), and dimethoxyethane (DME). Furthermore, if necessary, other reagents may be used. There is no particular limitation on the reagents, and examples thereof include acetylacetonate complexes such as iron acetylacetonate, halide salts such as FeCl₃, CuCl₂, CuBr₂, and perhalogen acid salts such as Fe(ClO₄)₃. Also, there is no particular limitation on reaction temperature, and examples thereof include -100°C to 200°C, and preferably include 0°C to 100°C.

It should be noted that in the polymerization, the compound of the present invention may be obtained as a mixture of polymeric compounds having different degrees of polymerization. In this case, in order to obtain a molecular aggregate having a uniform degree of polymerization, it is necessary to separate this mixture. There is no particular limitation on the separation method, and examples thereof include known methods such as column chromatography and GPC. After polymerization, or after separation and purification following polymerization, substituents X¹ and X² may be introduced, if necessary. Also, there is no particular limitation on the introduction method, and known methods and the like may be applied as appropriate.

### Example

Next, an example of the present invention is described.

In this example, following Scheme 1 below, thiophene (1T) in which two tert-butyldiphenylsilyl groups (TBDPS groups) were introduced via the fused cyclopetane ring, and covered oligothiophene having (1T) as a base unit were produced (synthesized). In this example including Scheme 1 below, a compound (nT) corresponds to a compound in which in Formula (II) above, both of X¹ and X² are a hydrogen atom. In the compound (nT), n is the degree of polymerization as n in Formula (II) above. In addition to (1T), (2T), (4T), (8T), and (16T) shown in Scheme 1, (3T), (6T), and (12T) also were synthesized and their property values were measured.

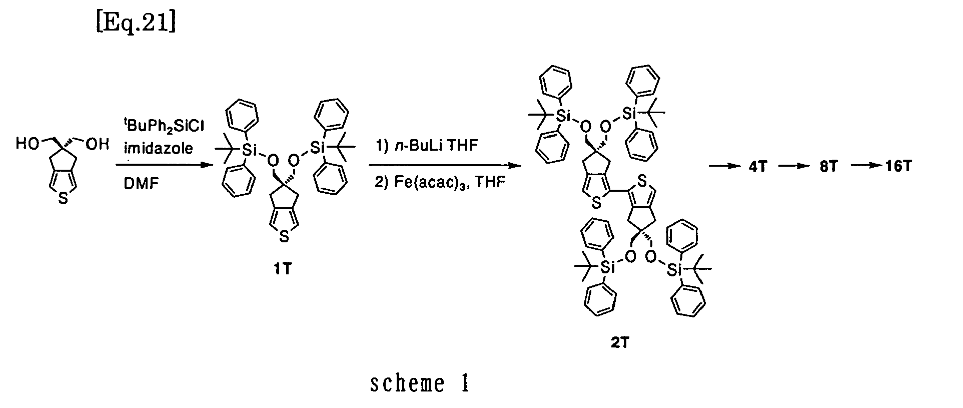

### (Measurement conditions etc.)

A nuclear magnetic resonance (NMR) spectrum was measured using a product named JMN-270 (270 MHz at the time of 1H measurement) manufactured by JEOL Ltd. Chemical shift is expressed in parts per million (ppm). Tetramethylsilane (TMS) was used as the internal standard 0 ppm. Coupling constant (J) is expressed in hertz, and the symbols s, d, t, q, m, and br respectively represent singlet, doublet, triplet, quartet, multiplet, and broad line. In mass spectrometry (MS), measurement was performed by MALDI-TOF, using a Voyager Linear DE-H (product name) manufactured by PerSeptive Biosystems. An ultraviolet and visible absorption spectrum (UV-VIS) was measured by a solution method, using a UV-3100PC (product name) manufactured by SHIMADZU CORPORATION. Measured values (wavelength) are expressed in nm. An infrared absorption spectrum (IR) was measured by a KBr method. Measured values (wavenumber) are expressed in cm⁻¹. In cyclic voltammetry, measurement was performed using a CV-50W (product name) manufactured by BAS Inc. Melting points were measured using a micro melting point meter manufactured by Yanagimoto Mfg. Co., Ltd. As silica gel in column chromatography separation, 40 to 50 µm of a product named Silica gel 60N manufactured by KANTO CHEMICAL CO., INC. was used. All chemical substances were in reagent grade, and were purchased from Wako Pure Chemical Industries, Ltd., TOKYO CHEMICAL INDUSTRY CO., LTD., KANTO CHEMICAL CO., INC., NACALAI TESQUE, INC., or SIGMA-ALDRICH Japan.

First, in the following manner, 1,3-dibromo-5,5-bis(ethoxycarbonyl)cyclopenta[c]thiophene was synthesized and then reduced, and thus 5,5-bis(hydroxymethyl)cyclopenta[c]thiophene serving as a starting material of Scheme 1 was obtained. It should be noted that this 5,5-bis(hydroxymethyl)cyclopenta[c]thiophene was synthesized referring to the description in Non-patent Document 1 (Aso, Y.; Otsubo, T. et al. J. Am. Chem. Soc. 2003, 125, 5286.).

### (1,3-dibromo-5,5-bis(ethoxycarbonyl)cyclopenta[c]thiophene)

First, a solvent mixture of toluene (293 mL), DMF (29 mL) and a sodium hydride, 60% in oil (9.5 g, 0.238 mol) was prepared. Next, the solvent was heated to 60°C, and an anhydrous toluene (225 mL) solution of diethyl malonate (17.4 g, 0.108 mol) and 2,5-dibromo-3,4-bis(bromomethyl) thiophene (45.0 g, 0.105 mol) was dropped onto this solvent under nitrogen atmosphere for 30 minutes. This mixture was agitated at 60°C for another 30 minutes, and then cooled to room temperature. Water (20 mL) was added carefully to the mixture, and an insoluble solid was removed by filtration with celite. An organic layer was separated from the obtained filtrate, and a water layer was extracted with dichloromethane (200 mL x 3). The organic layer and the extracted liquid were combined, washed with saturated brine, and dried with MgSO₄. Subsequently, the solvent was distilled off, and the obtained residue was purified by column chromatography (silica gel, dichloromethane : hexane = 1 : 1), recrystallization from hexane was allowed to occur, and thus colorless plate-like crystal of 1,3-dibromo-5,5-bis(ethoxycarbonyl)cyclopenta[c]thiophene was obtained (yield amount 25.5 g, yield percentage 56%). Data obtained by instrumental analysis of this compound is shown below.

1,3-dibromo-5,5-bis(ethoxycarbonyl)cyclopenta[c]thiophene:
melting point 82 to 83°C; ¹HNMR (270 MHz, CDCl₃) δ1.27 (t, 6H, J = 7.3 MHz, CH₃), 3.28 (s, 4H, CH₂), 4.22 (q, 4H, J = 7.3 Hz, CH₂); ¹³CNMR (100 MHz, CDCl₃) δ13.9, 36.1, 62.0, 64.6, 101.8, 144.5, 170.3; IR (KBr) v1730, 1252 cm⁻¹ (COO), MS (DI) m/z 424, 426, 428 (M⁺);
elemental analysis: based on C₁₃H₁₄O₄Br₂S, calculated value: C,36.64; H,3.31%, measured value: C,36.67; H,3.32%

### (5,5-bis(hydroxymethyl)cyclopenta[c]thiophene)

First, an anhydrous THF (120 mL) solution of lithium aluminium hydride (2.85 g, 75.1 mmol) was prepared. This solution was cooled with ice, and an anhydrous THF (30 mL) solution of 1,3-dibromo-5,5-bis(ethoxycarbonyl)cyclopenta[c]thiophene (8.0 g, 18.8 mmol) gradually was dropped onto this solution under nitrogen atmosphere. This mixed solution was refluxed for 20 hours, and then while this mixture was cooled with ice, ethyl acetate (30 mL), water (6 mL), and 1N (1 mol/L) hydrochloric acid (6 mL) were added successively in this order. An insoluble solid was removed by filtration, and the resultant was washed with acetone (100 mL x 3). The filtrate and the washed liquid were combined, and condensed under reduced pressure. The obtained solid was purified by column chromatography (silica gel, ethyl acetate), recrystallization from a mixed solvent containing ethyl acetate and chloroform in a ratio of 1 : 4 was allowed to occur, and thus colorless needle-like crystal of 5,5-bis(hydroxymethyl)cyclopenta[c]thiophene was obtained (yield amount 3.07 g, yield percentage 89%). Data obtained by instrumental analysis of this compound is shown below.

5,5-bis(hydroxymethyl)cyclopenta[c]thiophene:
decomposition point 139 to 141°C; ¹HNMR (270 MHz, CDCl₃) δ2.23 (t, 2H, J = 4.8 Hz, OH), 2.62 (s, 4H, CH₂), 3.77 (d, 4H, J = 4.8 Hz, CH₂, 6,79 (s, 2H, ArH); ¹³CNMR (100 MHz, CDCl₃) δ32.8, 55.9, 69.5, 115.4,145.9; IR (KBr) v3000-3600 cm⁻¹ (OH), MS (DI) m/z 184 (M⁺); elemental analysis: based on C₉H₁₂O₂S, calculated value: C,58.67; H,6.56%, measured value: C,58.55; H,6.74%

### [Synthesis of 5,5-bis(tert-butyldiphenylsilyloxy)cyclopenta[c]thiophene (1T)]

In the following manner, 5,5-bis(tert-butyldiphenylsilyloxy)cyclopenta[c]thiophene (1T) was synthesized from the starting material 5,5-bis(hydroxymethyl)cyclopenta[c]thiophene. More specifically, first, a dimethylformamide solution (25 mL) of 5,5-bis(hydroxymethyl)cyclopenta[c]thiophene (1.35 g, 7.3 mmol) and imidazole (2.01 g, 29.6 mmol) was prepared. Next, tert-butyldiphenylsilyl chloride (5 mL, 19.5 mmol) was dropped onto this solution at room temperature, and the mixture was agitated for four hours. Water was added to the thus obtained reaction liquid, and extraction was performed with ethyl acetate. An organic layer was washed with saturated brine, and then dried with anhydrous sodium sulphate.
After insoluble matters were removed by filtration, the solvent was distilled off under reduced pressure. The obtained residue was purified by silica gel column chromatography (hexane / chloroform (3 : 1)), and thus the compound (1T) was obtained as a colorless solid (yield amount 4.69 g, yield percentage 97%). Data obtained by instrumental analysis of this compound (1T) is shown below.

5,5-bis(tert-butyldiphenylsilyloxy)cyclopenta[c]thiophene (1T):
¹HNMR (CDCl₃-TMS): δ 1.03 (s, 18H), 2.60 (s, 4H), 3.74 (s, 4H), 6.69 (s, 4H), 7.26-7.42 (m, 12H), 7.60-7.64 (m, 8H). ¹³CNMR (CDCl₃): δ19.48, 26.94, 32.74, 57.95, 66.25, 114.67, 127.53,129.44, 133.45, 135.50, 146.58.

### [Synthesis of the compound (2T)]

First, a tetrahydrofuran solution (14 mL) of the compound (1T) (823 mg, 1.24 mmol) was prepared. Next, the solution was cooled to 0°C, and n-butyllithium (1.9 mL, 1.6M hexane solution) was dropped onto this solution at this temperature, and the mixture was agitated for one hour.
Furthermore, iron acetylacetonate (888 mg, 2.51 mmol) was added to the mixture, and the resultant was heated to 80°C, and then refluxed for one night. After completion of the reaction, the obtained reaction liquid was cooled to room temperature, and put in water, and then extraction was performed with chloroform. The organic layer was washed with saturated brine, and then dried with anhydrous sodium sulphate. After insoluble matters were removed by filtration, the solvent was distilled off under reduced pressure. The obtained residue was isolated and purified in a silica gel column (hexane / chloroform (2 : 1)), and thus the compound (2T) was obtained as a yellow solid (yield amount 700 mg, yield percentage 86%).
Data obtained by instrumental analysis of this compound (2T) is shown below.

Compound (2T):
¹HNMR (CDCl₃-TMS): δ 1.03 (s, 36H), 2.60 (s, 4H), 2.73 (s, 4H), 3.76 (s, 8H), 6.59 (s, 2H),7.21-7.36 (m, 24H), 7.60-7.65 (m, 16H). ¹³CNMR (CDCl₃): δ19.48, 26.99, 33.06, 34.05, 57.98, 66.35, 113.13, 127,53, 127.56, 133.30, 133.43, 135.49, 135.51, 141.88, 146.85. MS (m/z): 1326.1 (M⁺).

It should be noted that as a by-product in the synthesis of the (2T), the compound (3T) also was isolated and purified, and its property values were measured.

### [Synthesis of the compound (4T)]

The compound (4T) was synthesized (yield amount 737 mg, yield percentage 60%) by reaction and purification as in the synthesis of the compound (2T), except that the compound (2T) was used as a starting material instead of the compound (1T), and that the reaction temperature was set to -78°C instead of 0°C. Data obtained by instrumental analysis of this compound (4T) is shown below.

Compound (4T):
¹HNMR (CDCl₃-TMS): δ 0.89 (s, 36H), 0.90 (s, 36H), 2.47 (s, 4H), 2.59 (s, 4H), 2.64 (s, 8H), 3.67 (s, 8H), 3.73 (s, 8H), 6.48 (s, 2H), 7.03-7.25 (m, 24H), 7.46-7.57 (m, 16H). ¹³CNMR (CDCl₃): δ19.41, 26.93, 26.97, 33.64, 34.09, 34.78, 57.88, 57.97, 66.16, 113.23, 125.99, 126.07, 127.49, 127.53, 127.56, 129,42, 133.04, 133.07, 133.38, 133.49, 135.46, 135.50, 141.36, 141.83, 142.56, 147.21. MS (m/z): 2643.5 (M⁺).

Furthermore, as a by-product in the synthesis of the (4T), the compound (6T) was isolated and purified, and its property values were measured. Data obtained by instrumental analysis is shown below.

Compound (6T):
¹HNMR (CDCl₃-TMS): δ 0.89 (s, 36H), 0.93 (s, 36H), 1.00 (s, 36H), 2.53 (s, 4H),2.63 (s, 12H), 2.66 (s, 4H), 2.68 (s, 4H), 3.72 (s, 8H), 3.78 (s, 16H), 6.55 (s, 2H), 7.04-7.32 (m, 72H), 7.49-7.62 (m, 48H). MS (m/z): 3963.3 (M⁺).

### [Synthesis of the compound (8T)]

The compound (8T) was synthesized (yield amount 176 mg, yield percentage 30%) by reaction and purification as in the synthesis of the compound (2T), except that the compound (4T) was used as a starting material instead of the compound (1T), and that the reaction temperature was set to -78°C instead of 0°C. Data obtained by instrumental analysis of this compound (8T) is shown below.

Compound (8T):
¹HNMR (CDCl₃-TMS): δ 0.87 (s, 72H), 0.93 (s, 36H), 0.95 (s, 36H), 2.54-2.66 (m, 32H), 3.63 (m, 32H), 6.56 (s, 2H), 7.03-7.25 (m), 7.46-7.57 (m). MS (m/z): 5270.7 (M⁺).

Furthermore, as a by-product in the synthesis of the (8T), the compound (12T) was isolated and purified, and its property values were measured. Data obtained by instrumental analysis is shown below.

Compound (12T):
¹HNMR (CDCl₃-TMS): δ 0.84-0.94 (m), 2.59 (m), 3.76 (m), 6.56 (s), 7.06-7.33 (m), 7.51-7.59 (m). MS (m/z): 7758.1 (M⁺).

Furthermore, the compound (16T) also was synthesized by reaction and purification as in the synthesis of the compounds (4T) and (8T), except that the compound (8T) was used as a starting material.

In this manner, first, a thiophene monomer unit (1T) was synthesized, and then oligomers (2T) to (16T) were synthesized by repeating oxidative polymerization.

### (Molecular structure and electrical properties)

The molecular structure and electrical properties of the thus synthesized compounds of this example were measured.

First, the electron absorption degree of the compounds (2T), (3T), (4T), (6T), (8T), and (12T) was obtained by ultraviolet and visible absorption spectrum (UV-VIS) measurement. FIG. 1 shows the results. In FIG. 1, the horizontal line indicates the wavelength of light, and the vertical line indicates the electron absorption coefficient (ε). For the sake of convenience, the view is enlarged such that ε is multiplied by two in (2T) and ε is multiplied by 1.5 in (3T), respectively. As shown in FIG. 1, the absorption peak wavelength of the compounds of this example regularly is shifted toward the longer wavelength side in accordance with increase in the degree of polymerization. More specifically, π electronic conjugation in the oligothiophene structure effectively is kept. The reason for this seems to be that the oligothiophene structure, that is, π-conjugation framework was covered with a bulky tert-butyldiphenylsilyl group, and thus the planarity the π-conjugation framework was kept, and π-stacking interaction between molecules and the like were inhibited.

Furthermore, also based on the reduction potential in cyclic voltammetry, it was confirmed that the π electronic conjugation effectively was kept. Moreover, the compound (4T) and the like were subjected to X-ray crystal structure analysis, it was confirmed that the planarity of the oligothiophene structure, that is, the π-conjugation framework was kept well.

### Industrial Applicability

As described above, in the compound of the present invention, a hetero ring effectively is covered, and the compound is suitable for electronic materials and the like. According to the compound of the present invention, its hetero ring effectively is covered, and thus measurement of the electrical conductivity of monomolecules of an oligoheterocyclic compound such as oligothiophene, which has been difficult in the case of conventional oligothiophene and the like, can be performed. From this point of view, the compound of the present invention is useful also as a research tool for clarifying electrical properties according to the degree of polymerization of oligoheterocyclic compounds. Furthermore, by effectively keeping π electronic conjugation by covering, the compound of the present invention also can be applied to molecular wires that are important in molecular electronics devices. Applications of the compound of the present invention are not limited to these, and the compound can be used for any applications.

## Claims

1. A compound represented by Formula (I), a tautomer or a stereoisomer thereof, or a salt thereof 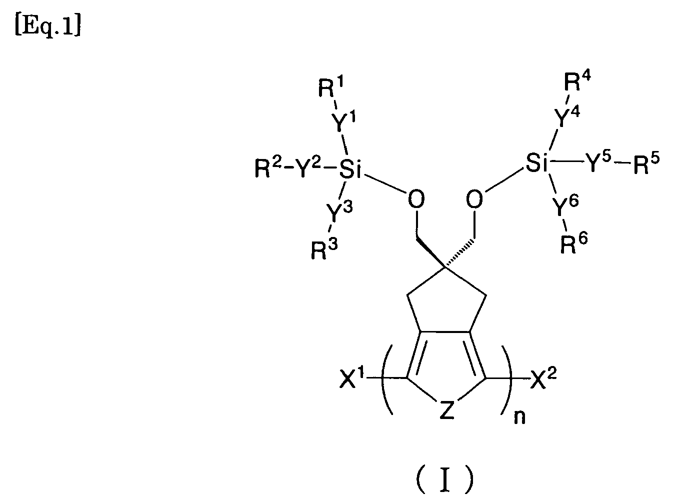 wherein, in Formula (I),
Y¹ to Y⁶ each independently are an oxygen atom or a bond,
R¹ to R⁶ each independently are a hydrogen atom, a linear chain or branched chain (may or may not contain a hetero atom, may or may not contain an unsaturated bond, and may or may not contain a ring structure, in the main chain and side chain), or a carbocyclic ring or a hetero ring (may be a monocyclic ring or a fused ring, may be saturated or unsaturated, and may or may not have a substituent), or at least two of R¹ to R³ together may form a ring with a silicon atom bonded thereto, and at least two of R⁴ to R⁶ together may form a ring with a silicon atom bonded thereto,
Z is an atom or an atomic group represented by any one of Formulae (i) to (vii): 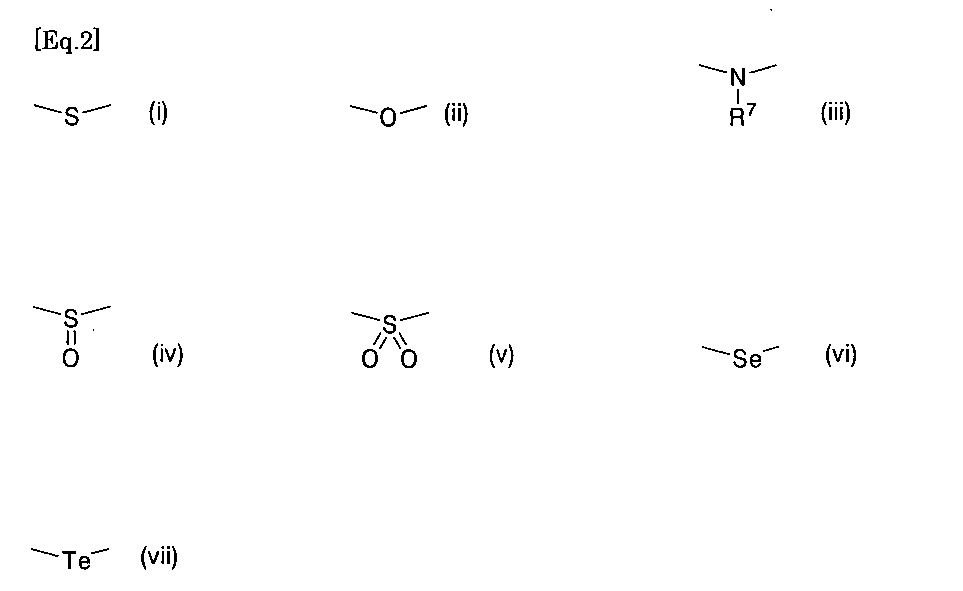
R⁷ is a hydrogen atom or a hydrocarbon group (may be saturated or unsaturated, and may be linear, branched, or cyclic), and further may be substituted with at least one substituent,
X¹ and X² each independently are a hydrogen atom or a polar group, and
n is a positive integer.

2. The compound, tautomer or stereoisomer thereof, or salt thereof according to claim 1,
wherein R¹ to R⁶ each independently are a hydrogen atom, linear chain or branched chain having 1 to 18 carbon atoms (may or may not contain a hetero atom, may or may not contain an unsaturated bond, and may or may not contain a ring structure, in the main chain and side chain), or a cyclic substituent having a structure in which any one hydrogen has been removed from a compound represented by any one of Formulae (1) to (67) (the cyclic substituent further may be substituted with one or a plurality of substituents, and the substituents each independently are halogen, a methyl group, a hydroxy group, a methoxy group, an oxo group, or an amino group): 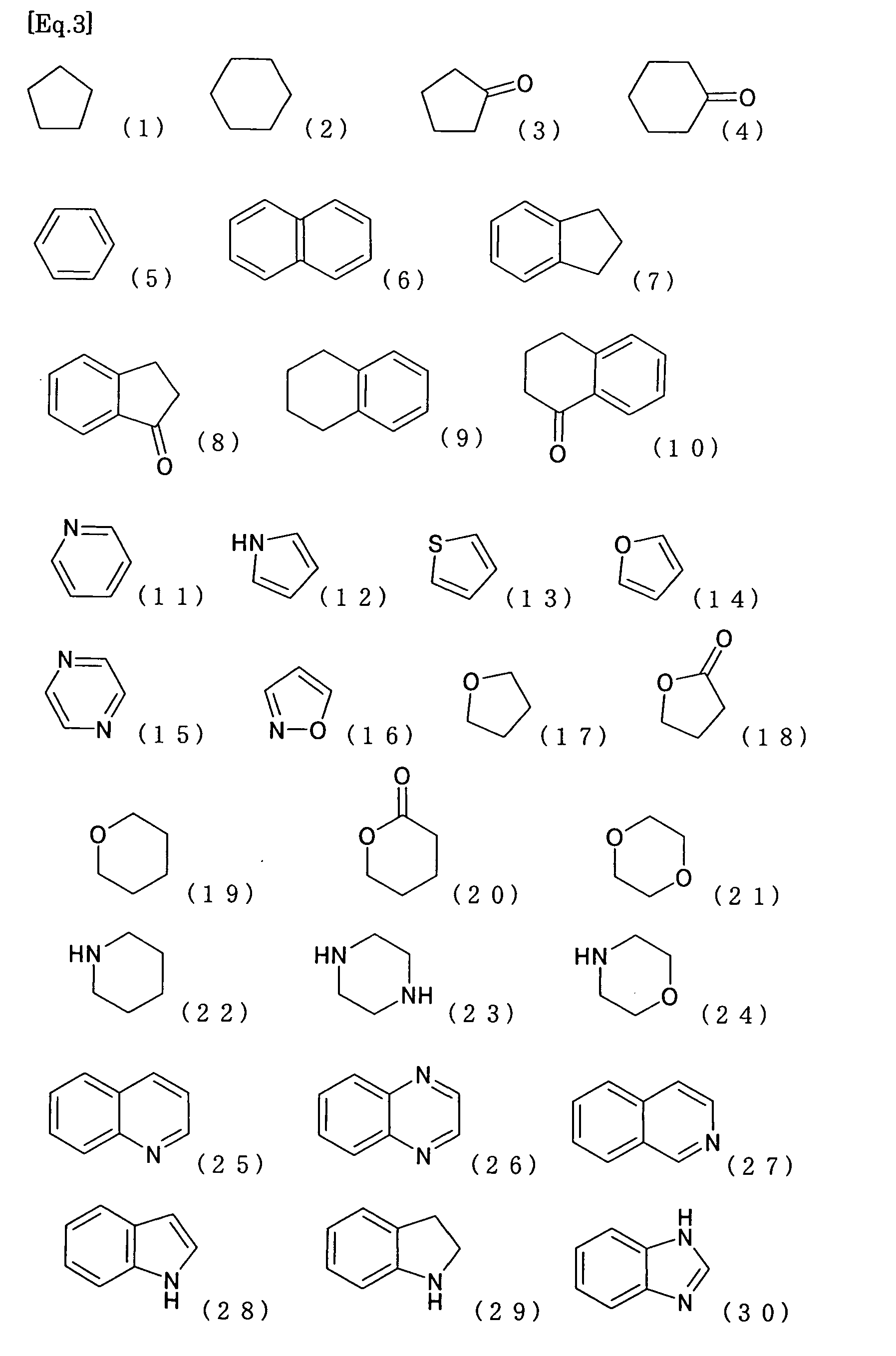 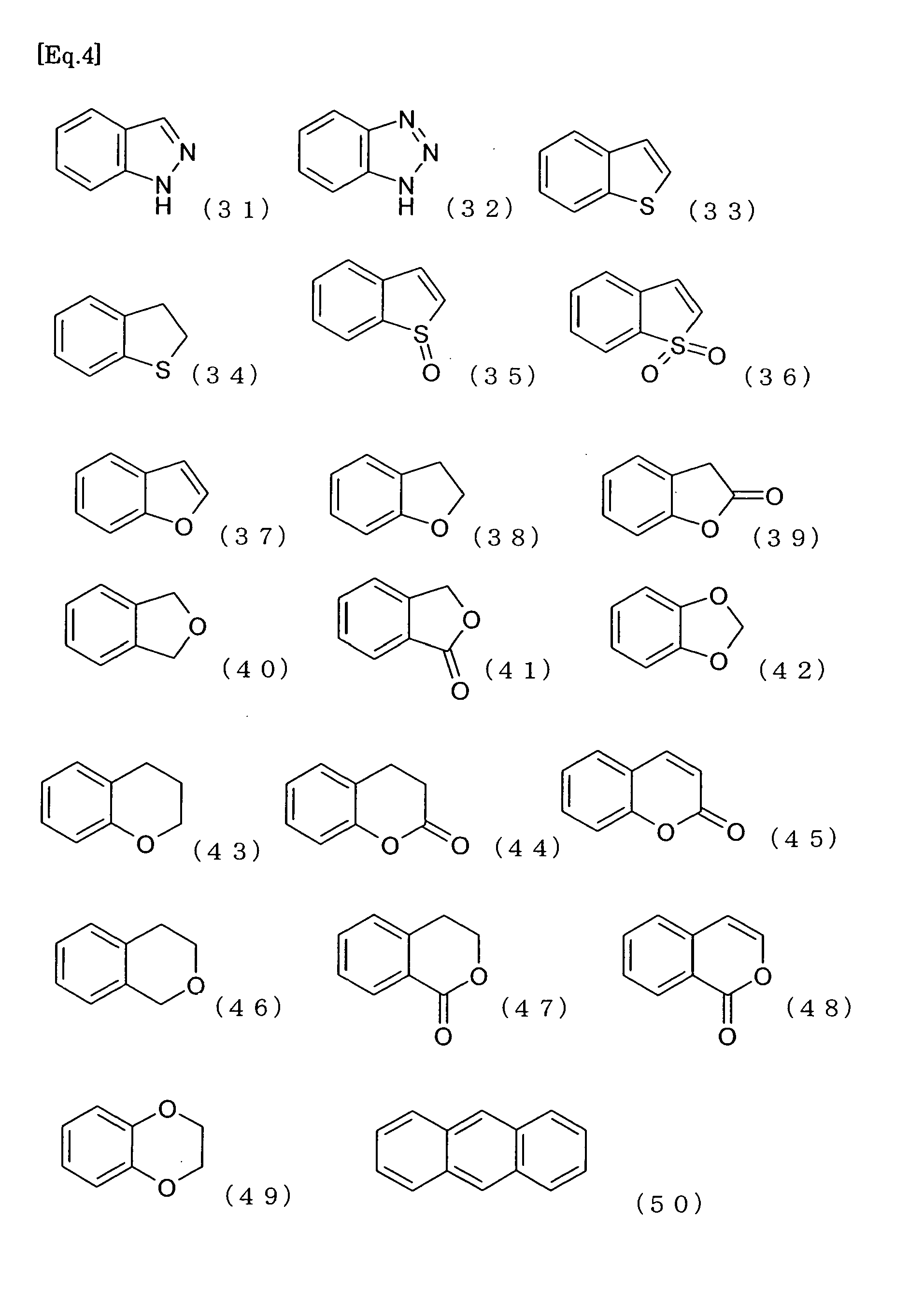 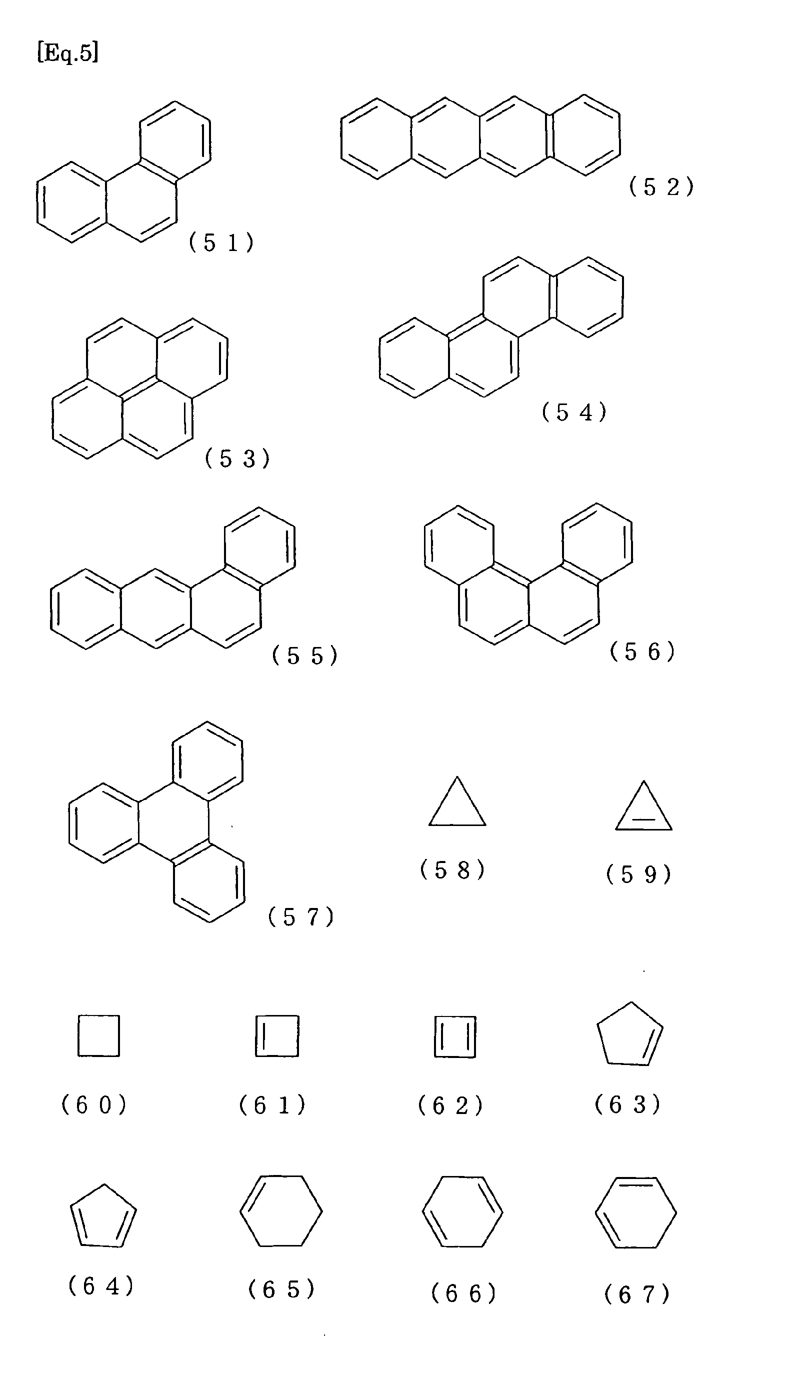 at least two of R¹ to R³ together may form a ring with a silicon atom bonded thereto, and at least two of R⁴ to R⁶ together may form a ring with a silicon atom bonded thereto.

3. The compound, tautomer or stereoisomer thereof, or salt thereof according to claim 1,
wherein R¹ to R⁶ each independently are a hydrogen atom, a linear or branched alkyl group having 1 to 18 carbon atoms, a linear or branched unsaturated hydrocarbon group having 2 to 18 carbon atoms, a phenyl group, a 1-naphthyl group, a 2-naphthyl group, a 1-anthryl group, a 2-anthryl group, or a 9-anthryl group, and the groups further may be substituted with at least one substituent, or at least two of R¹ to R³ together may form a ring with a silicon atom bonded thereto, and at least two of R⁴ to R⁶ together may form a ring with a silicon atom bonded thereto, and
R⁷ is a hydrogen atom, a linear or branched alkyl group having 1 to 6 carbon atoms, or a linear or branched unsaturated hydrocarbon group having 2 to 6 carbon atoms, and further may be substituted with at least one substituent.

4. The compound, tautomer or stereoisomer thereof, or salt thereof according to claim 1, wherein R¹ to R⁶ each independently are a hydrogen atom, a linear or branched alkyl group having 1 to 6 carbon atoms, a linear or branched unsaturated hydrocarbon group having 2 to 6 carbon atoms, a phenyl group, a 1-naphthyl group, a 2-naphthyl group, a 1-anthryl group, a 2-anthryl group, or a 9-anthryl group, and R⁷ is a hydrogen atom or a methyl group.

5. The compound, tautomer or stereoisomer thereof, or salt thereof according to claim 1, wherein R¹ to R⁶ each independently are a hydrogen atom, a methyl group, an ethyl group, an n-propyl group, an isopropyl group, an n-butyl group, an isobutyl group, a sec-butyl group, a tert-butyl group, a phenyl group, a 1-naphthyl group, a 2-naphthyl group, a 1-anthryl group, a 2-anthryl group, or a 9-anthryl group, and R⁷ is a hydrogen atom or a methyl group.

6. The compound, tautomer or stereoisomer thereof, or salt thereof according to claim 1, wherein the compound is represented by Formula (II): 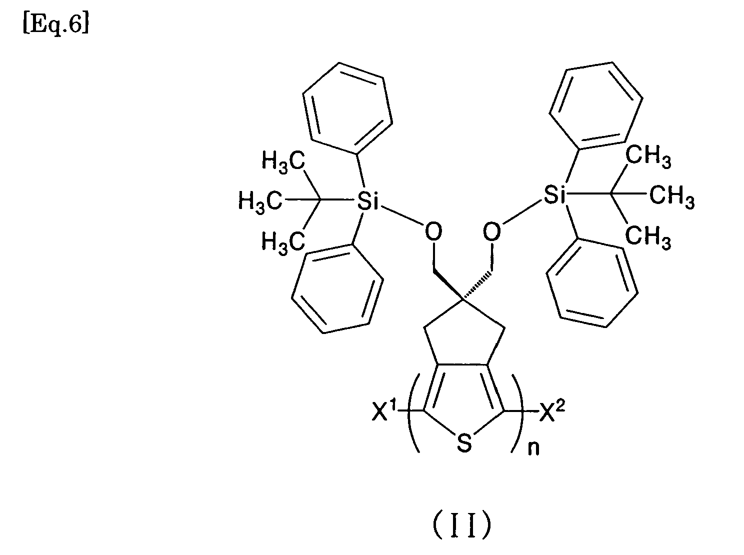 wherein, in Formula (II), X¹, X² and n respectively are the same as those in Formula (I).

7. The compound, tautomer or stereoisomer thereof, or salt thereof according to claim 1, wherein X¹ and X² each independently are a hydrogen atom, a mercapto group (-SH), or a substituent represented by any one of Formulae (viii) to (xvi): 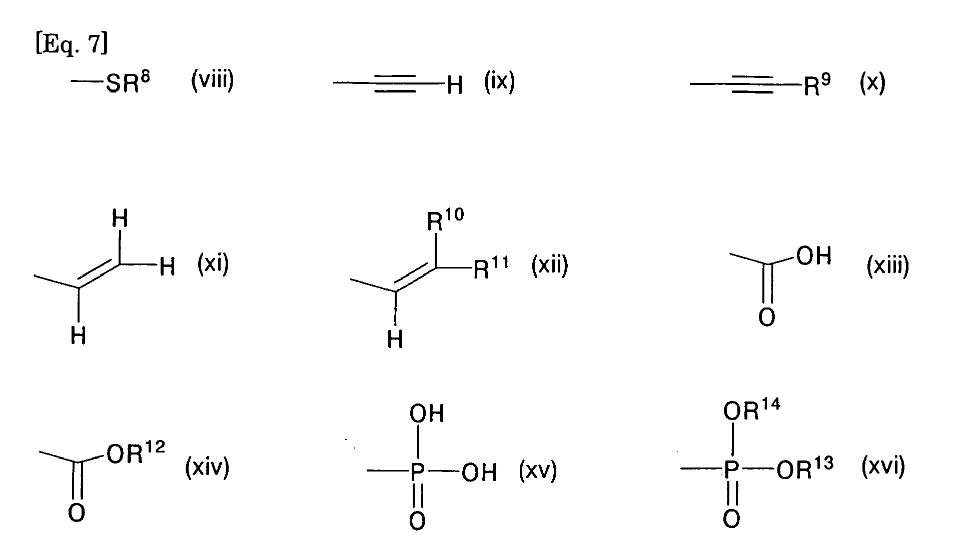 wherein, in Formulae (viii) to (xvi), R⁸ to R¹⁴ each independently are a linear or branched alkyl group, a cycloalkyl group, or an aromatic ring, one of R¹⁰ and R¹¹ may be a hydrogen atom, and one of R¹³ and R¹⁴ may be a hydrogen atom.

8. The compound, tautomer or stereoisomer thereof, or salt thereof according to claim 1, wherein n is a multiple of 2.

9. The compound, tautomer or stereoisomer thereof, or salt thereof according to claim 1, wherein n is 1 to 96.

10. The compound, tautomer or stereoisomer thereof, or salt thereof according to claim 1, wherein n is 1, 2, 4, 6, 8, 12, or 16.

11. A method for preparing the compound, tautomer or stereoisomer thereof, or salt thereof according to claim 1, comprising a step of preparing a compound represented by Formula (VI) by coupling reaction of compounds represented by Formulae (III) to (V): 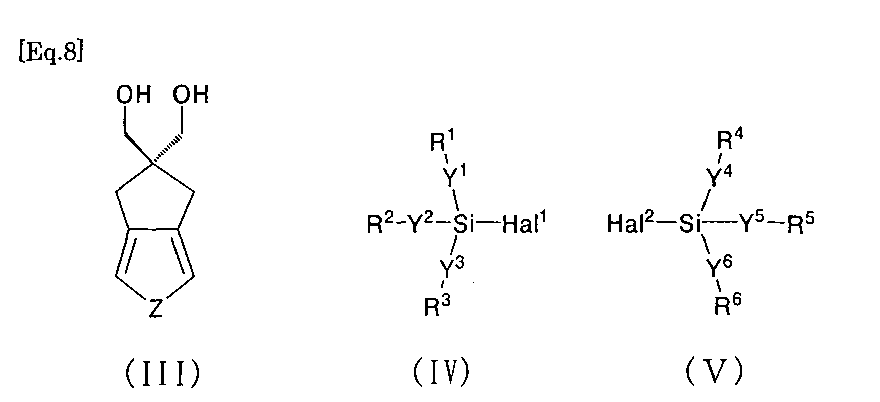 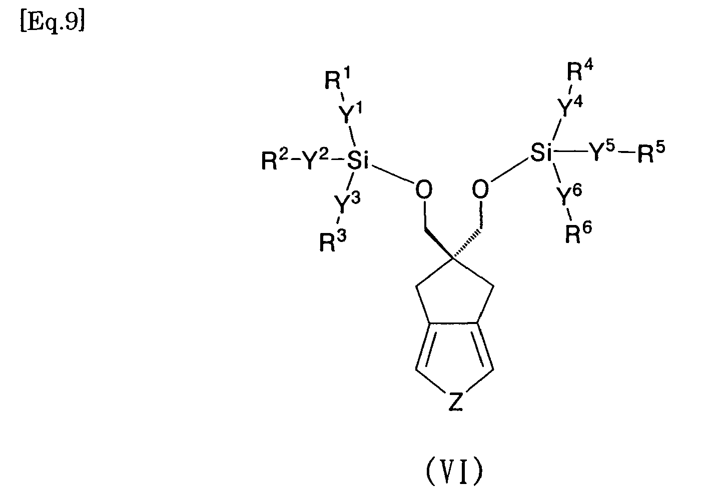 wherein, in Formulae (III) to (VI), Y¹ to Y⁶, R¹ to R⁶, and Z respectively are the same as those in Formula (I), and Hal¹ and Hal² each independently are chlorine, bromine, or iodine.

12. The preparing method according to claim 11, further comprising a step of polymerizing the compound represented by Formula (VI).

13. The preparing method according to claim 12, further comprising a step of further polymerizing a product obtained in the polymerization step.

14. The preparing method according to claim 12, wherein the polymerization is oxidative polymerization using an organic lithiation agent.

15. A molecular aggregate comprising the compound, tautomer or stereoisomer thereof, or salt thereof according to claim 1, wherein a degree of polymerization n of molecules of the compounds is uniform in the molecular aggregate.

16. The molecular aggregate according to claim 15, for measuring electrical properties of a framework represented by Formula (VII): 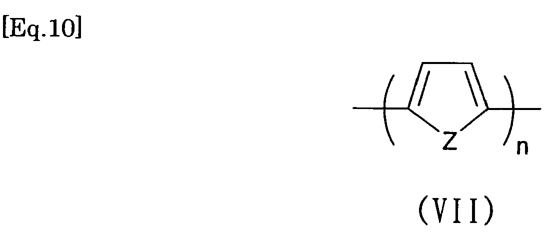 wherein, in Formula (VII), Z and n respectively are the same as those in Formula (I).

17. An electronic material comprising the compound, tautomer or stereoisomer thereof, or salt thereof according to claim 1, or the molecular aggregate according to claim 15.

18. A semiconductor comprising the compound, tautomer or stereoisomer thereof, or salt thereof according to claim 1, or the molecular aggregate according to claim 15.
